# EUROPEAN PATENT APPLICATION

(11) **EP 2 899 864 A1**
(43) Date of publication of application: **29.07.2015**
(21) Application number: 13838527.3
(22) Date of filing: 03.07.2013
(51) Int. Cl.: H02M 7/00, H05K 7/20, H05K 7/14

(54) **POWER CONVERSION DEVICE**

(30) Priority: 19.09.2012 JP 2012205958
(71) Applicant: Nissan Motor Company, Limited, Kanagawa-ku Yokohama-shi Kanagawa 221-0023 (JP)
(72) Inventor: SUZUKI, Kenta, Atsugi-shi Kanagawa 243-0123 (JP)
(74) Representative: Grünecker Patent- und Rechtsanwälte PartG mbB
(86) International application number: PCT/JP2013/004141
(87) International publication number: WO 2014/045499

(57) **Abstract**

To reduce the diameter of a power conversion apparatus. The power conversion apparatus comprises power modules (2), a shielding plate (3), and a bus bar (6) electrically connected with the power modules (2), which are disposed to be layered in this order on one side of a heatsink (1). The plural power modules (2) are annularly disposed along a surface of the heatsink (1). Then, the power modules (2) disposed annularly, the shielding plate (3), and the bus bar (6) are disposed to overlap each other at least partially when viewed in a layering direction.

## Description

### Technical Field

This disclosure relates to a power conversion apparatus capable of being used as an inverter electrically connected with an electric motor.

### Background Art

As a power conversion apparatus, for example, an apparatus described in PTL 1 is known. In this apparatus, plural switching devices are disposed on a metal member for cooling a ring-panel-shaped device so as to be disposed in a circumferential direction with predetermined intervals. That is, power modules are disposed annularly. Furthermore, a ring-shaped or an arc-shaped bus bar is disposed inner than an inner circumference of the power module.

### Citation List

### Patent Literature

PTL1: JP 2007-116840 A

### Summary of Invention

### Technical Problem

In the above-mentioned power conversion apparatus, it is necessary to dispose the bus bar on the inner side of the annular power module, thus the inner diameter of the annular power module increases accordingly. As a result, there is problem that the whole diameter of the power conversion apparatus increases.

The present invention has been made in view of the above problem, and has an object to reduce the diameter of the power conversion apparatus.

### Solution to Problem

In order to solve the above-mentioned problem, according to an aspect of the present disclosure, there is provided a power conversion apparatus including power modules, a shielding plate, and a bus bar electrically connected with the power modules, which are disposed to be layered in this order on one side of a heatsink. The power modules are disposed annularly along a surface of the heatsink. Furthermore, the power modules disposed annularly, the shielding plate, and the bus bar are disposed to overlap each other when viewed in a layering direction.

### Advantageous Effects of Invention

According to an aspect of the present disclosure, the power modules disposed annularly, the shielding plate, and the bus bar are disposed to be layered in this order. Therefore, it is possible to suppress unnecessary interference between the power modules and the bus bar with the shielding plate as well as to reduce a diameter of the power conversion apparatus.

### Brief Description of Drawings

FIG. 1 is a perspective, cross-sectional view of a power conversion apparatus according to an embodiment of the present invention;
FIG. 2 is a conceptual view schematically illustrating a layer construction of a power conversion apparatus according to an embodiment of the present invention;
FIG. 3A to FIG. 3C are views illustrating a shielding plate and a bus bar;
FIG. 4 is a side view illustrating a supporting structure of a driver circuit substrate on a heatsink;
FIG. 5 is a side view illustrating a supporting structure of a shielding plate on a heatsink; and
FIG. 6 is a view illustrating a configuration of another bus bar.

### Description of Embodiments

Hereinafter, embodiments of the present invention will now be described with reference to the drawings.

### (First Embodiment)

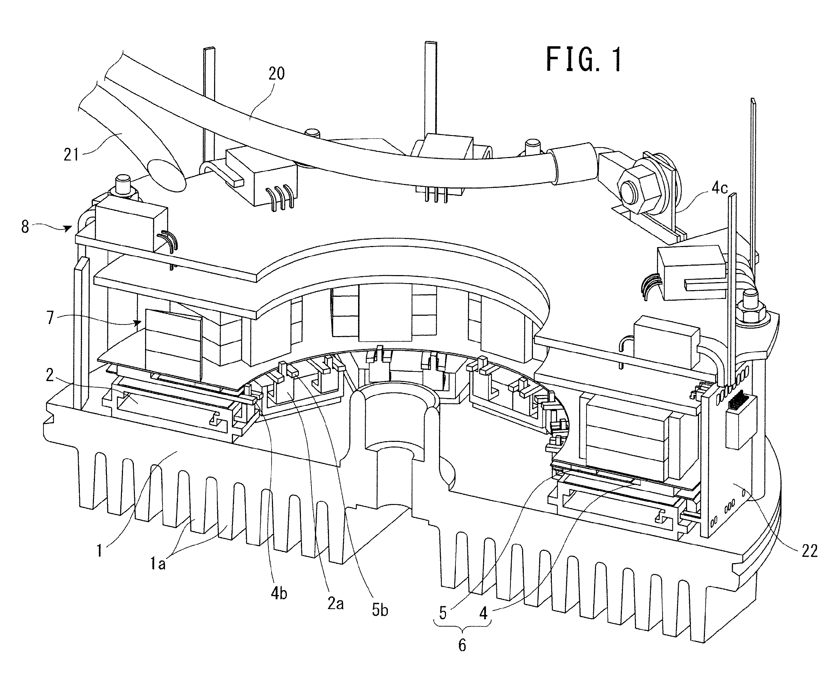

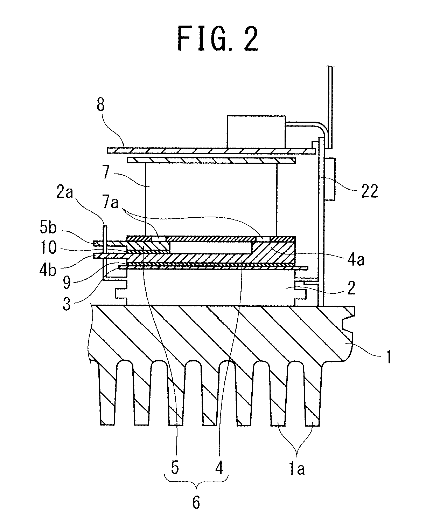

FIG. 1 is an illustrative cross-sectional view illustrating a power conversion apparatus according to an embodiment of the present invention being cut. FIG. 2 is a conceptual view schematically illustrating a layer construction of the power conversion apparatus.

Herein, the power conversion apparatus described below may have an integrated structure with an electric motor to be controlled (not illustrated). The electric motor (not illustrated) and the power conversion apparatus may be separate from each other. Furthermore, in the following description, the case (not illustrated) forming an outer shape of the power conversion apparatus is assumed to be a cylindrical shape. However, the outer shape of the power conversion apparatus is not limited to the cylindrical shape.

### (Configuration)

As illustrated in FIG. 1, the power conversion apparatus according to the present embodiment is configured by layering a heatsink 1, power modules 2, a shielding plate 3, a bus bar 6, smoothing capacitors 7, and a driver circuit substrate 8, in this order along the axis direction of a circular ring (the vertical direction in FIG. 1). It is to be noted that the drawings do not indicate an orientation in using the power conversion apparatus.

The heatsink 1 is formed in an annular shape. In FIG. 1, plural cooling fins 1a are integrally formed on the under surface of the heatsink 1. The plural power modules 2 are mounted on the upper surface of the heatsink 1 along the circumferential direction of the heatsink 1 with predetermined intervals. That is, the plural power modules 2 are disposed annularly. The power modules 2 are switching devices, for example. The power modules 2 are mounted on the heatsink 1 with high thermal conductivity in order to dissipate the heat generated by the power modules 2. It is to be noted that the heatsink 1 does not have to be formed in an annular shape.

The disk-shaped shielding plate 3 is coaxially disposed to be layered on the plural power modules 2 disposed annularly. The shielding plate 3 is fixed to the power modules 2 with an adhesive.

The disk-shaped bus bar 6 is coaxially disposed to be layered on the shielding plate 3 in the axis direction of the circular ring. The bus bar 6 includes a tabular P-conductor 5 and a tabular N-conductor 4 which are coaxially layered in the axis direction of the circular ring. In the example of the present embodiment, the N-conductor 4 is located on the shielding plate 3 side, and the P-conductor 5 is located on the smoothing capacitors 7 side in the layering direction. The P-conductor 5 and the N-conductor 4 includes terminals 4b and 5b at their inner diameter side, respectively, which protrude in the inner diameter directions. The terminals 4b and 5b are connected with an output terminals 2a of the power modules 2. Thus, the bus bar 6 is electrically connected with semiconductor devices of the power modules 2 such that an electric power can be supplied. The electric connection may be a connection with a low resistance.

The shielding plate 3 and the N-conductor 4 are bonded to be integrated by an adhesive insulation sheet 9 inserted therebetween. Similarly, the N-conductor 4 and the P-conductor 5 are bonded to be integrated by an adhesive insulation sheet 10 inserted therebetween. Thus, the bus bar 6 is adhesively fixed on the upper surface of the power modules 2 via the shielding plate 3.

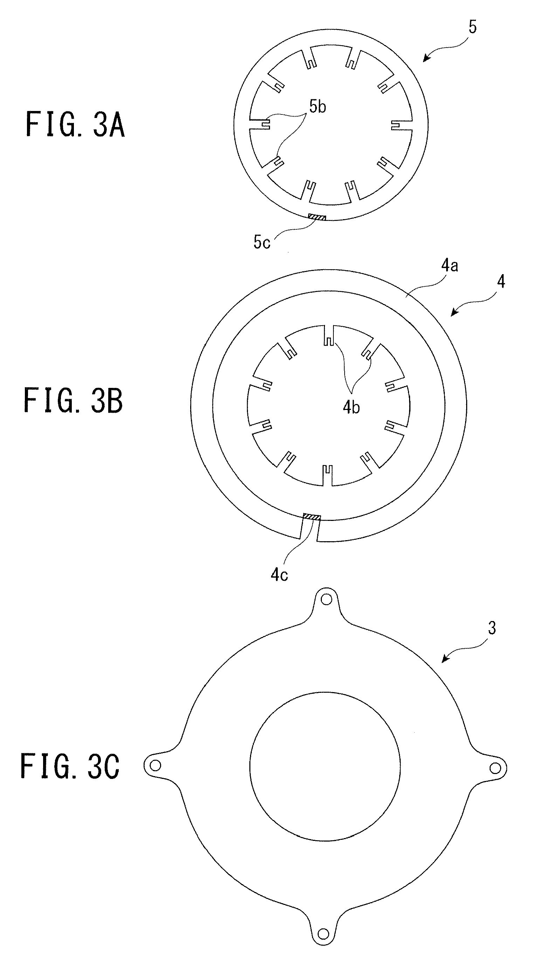

Herein, as illustrated in FIG. 3, the width of the N-conductor 4 which is located on the lower side is set to be larger than the width of the P-conductor 5. The P-conductor 5 has a configuration annularly exposing the outer circumference of the N-conductor 4 in a top view. That is, the N-conductor 4 has a shape protruding to the outer diameter side compared to the P-conductor 5 on the upper side. That is, the N-conductor 4 has a disk-shape the outer diameter of which is larger than the outer diameter of the P-conductor 5. The protruding portion forms a non-overlapping portion. The non-overlapping portion protrudes to the upper side to form a step portion 4a at the position in the diameter direction where the non-overlapping portion faces the output terminals of the smoothing capacitors 7. The protruding amount of the step portion 4a upward is set such that the height of the protruding face which is the upper surface of the step portion 4a is equal to that of the upper surface of the P-conductor 5 (a surface facing the smoothing capacitors 7). In this embodiment, the step portion 4a formed by increasing the plate thickness is exemplified as illustrated in FIG. 2. However, the step portion 4a may be formed by bending a part of a plate forming the N-conductor 4 upward.

Herein, the outer diameter of the disk-shaped shielding plate 3 is set to be larger than the outer diameter of the bus bar 6. That is, when viewed in the layering direction, the shielding plate includes a shielding plate body completely overlapping the bus bar, and protruding portions which protrude from the shielding plate body to at least one of the inner diameter direction and the outer diameter direction and do not overlap the bus bar. In the present embodiment, the protruding portions formed on only the outer shape side is exemplified.

The smoothing capacitors 7 are mounted on the upper surface of the bus bar 6 (a surface opposite to the surface facing the shielding plate 3) including the layered N-conductor 4 and P-conductor 5. In the present embodiment, the plural smoothing capacitors 7 are disposed along the circumferential direction of the bus bar 6 with predetermined intervals such that the plural smoothing capacitors 7 are annularly disposed. Each of the smoothing capacitors 7 has a pair of terminals 7a protruding downward. The protruding amounts of the pair of terminals 7a is set to be equal to each other. Furthermore, the pair of terminals 7a is arranged in the diameter direction of the bus bar 6. The inner terminal 7a contacts with the P-conductor 5, and the outer terminal 7a contacts with the upper surface of the step portion 4a of the N-conductor 4. In this way, the smoothing capacitors 7 and the bus bar 6 are connected with each other in order to suppress electric ripples in the bus bar 6. The connection may be a connection with an electrically low resistance.

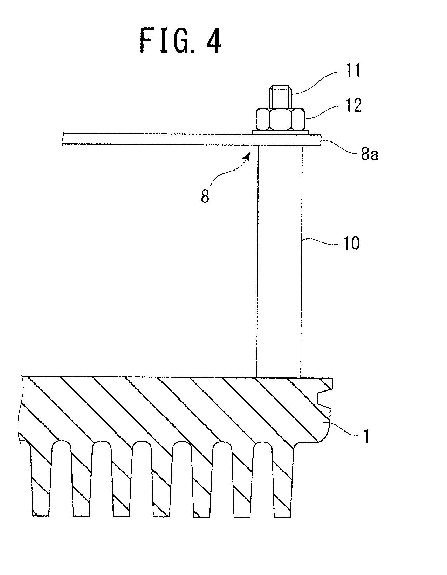

The driver circuit substrate 8 is disposed to be layered on the upper side of the annular smoothing capacitors 7. The driver circuit substrate 8 is supported on the heatsink 1 by bolting to the heatsink 1, as illustrated in FIG. 4. Specifically, a support pillar 10 is provided to stand upward (in the layering direction) from the heatsink 1, as illustrated in FIG. 4. The threaded shaft 11 protrudes upward from the upper end of the support pillar 10. The threaded shaft 11 is inserted into a mounting hole (not illustrated) of a mounting portion 8a formed on the driver circuit substrate 8, and a nut 12 is attached to the threaded shaft 11 by screwing in a state where the support pillar 10 supports the driver circuit substrate 8. Furthermore, the devices on the driver circuit substrate 8 is electrically connected with the power modules 2 via a substrate 22 as illustrated in FIG. 2 in order to control the power modules 2. The connection may be a connection with an electrically low resistance.

In the above description, there are described the power modules 2 and the smoothing capacitors 7 of the so-called "circumferential direction divided type" which are divided in the circumferential direction, respectively. The power modules 2 and the smoothing capacitors 7 may be the so-called integral cylinder type, which have a cylindrical shape, respectively, or the like. Furthermore, the smoothing capacitors 7 may be aluminum electrolytic capacitors, film capacitors, ceramic capacitors, or the like, but not limited thereto.

Electricity supply paths 4c and 5c are integrally formed with the N-conductor 4 and the P-conductor 5, respectively, which form the bus bar 6. The electricity supply paths 4c and 5c rise upward (in a direction which departs from the heatsink 1), and the end portions of the electricity supply paths 4c and 5c are connected with power supply cables 20 and 21, respectively. The power supply cables 20 and 21 are lead out of the case (not illustrated) which accommodates the above-mentioned modules of the power conversion apparatus.

### (First Modification)

In the above-mentioned embodiment, the shielding plate 3 and the bus bar 6 are fixed to the heatsink 1 via the power modules 2 with the adhesive.

Alternatively, the shielding plate 3 may be fixed to the heatsink 1 directly. By fixing the shielding plate 3 to the heatsink 1 directly, the bus bar 6 bonded to the shielding plate 3 is supported by and fixed to the heatsink 1, and thus, the positioning of the bus bar 6 becomes more secure.

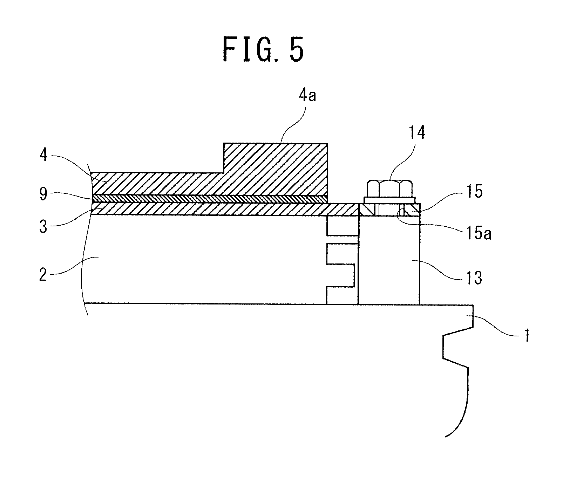

FIG. 5 illustrates an example of mounting of the shielding plate 3 to the heatsink 1.

In this example, the shielding plate 3 has a plate-like mounting portion 15 protruding outward. A hole 15a penetrating vertically is formed in the mounting portion 15.

Furthermore, a cylindrical body 13 rising upward from the heatsink 1 is formed. An internal thread is formed on the inner diametric surface of the cylindrical body 13. Then, the hole 15a of the mounting portion 15 and the hole of the cylindrical body 13 are coaxially disposed and the bolt 14 is inserted from above and screwed. Thus, the shielding plate 3 is fixed to the heatsink 1. The two or more mounting portions and the cylindrical bodies may be formed along the circumferential direction. It is to be noted that the mounting may be performed by swaging, welding, or other known fixing means.

### (Second Modification)

In the bus bar exemplified above, as illustrated in FIG. 3, the connection terminals 4b and 5b protrude toward the inner circumference, and the step portion 4a, and the electricity supply paths 4c and 5c are formed on the outer circumference side. The bus bar 6 is not limited thereto.

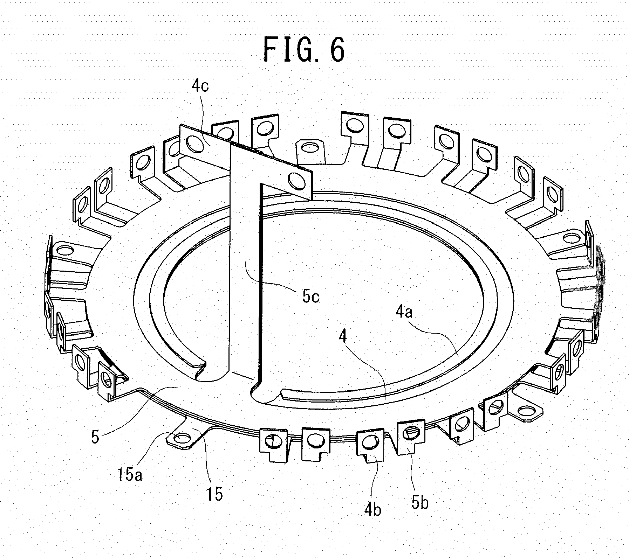

As illustrated in FIG. 6, the step portion 4a, and the electricity supply paths 4c and 5c may be formed on the inner circumference side. In this drawing, the connection terminals 4b and 5b are formed on the outer circumference side.

In the second modification, the step portion 4a is formed in an annular shape having a notch portion partially, that is a C-shape, when viewed in the layering direction. Then, the electricity supply paths 4c and 5c rise upward at the notch portion. The same applies to the FIG. 3.

In the second modification, the N-conductor 4 constitutes a first conductor and the P-conductor 5 constitutes a second conductor.

### (Operation etc.)

(1) The power conversion apparatus according to the present embodiment has the power modules 2 disposed in the circumferential direction, and thus the plural power modules 2 are annularly disposed. Furthermore, the disk-shaped bus bar 6 is disposed to be layered on the plural power modules 2 annularly disposed. Therefore, the plural power modules 2 have an even relationship each other. Thus, a wiring inductance is reduced and unevenness in the current (unevenness in heat generation) in parallel driving of phases is prevented.
(2) The P-conductor 5, the N-conductor 4 and the shielding plate 3 are integrated in a state where they are closed to one another, by the film-like adhesive insulation sheets.

Therefore, it is possible to dispose the P-conductor 5, the N-conductor 4 and the shielding plate 3 to be layered in the state where they are closed to one another, and to integrate the P-conductor 5, the N-conductor 4 and the shielding plate 3.

It is to be noted that, by bonding the bus bar 6 to the shielding plate 3 and by fixing the shielding plate 3, it is possible to position the bus bar 6 indirectly.

(3) Furthermore, the bus bar 6 including the P-conductor 5 and the N-conductor 4 is disposed to be layered on the power modules 2 annularly disposed.

That is, the bus bar 6 is disposed to be layered on the power modules 2 without disposing the bus bar 6 on the inner diameter side of the power modules 2. Therefore, it is possible to design to deduce the diameter of the annular power modules 2 accordingly. In this configuration, the shielding plate 3 is disposed between the PN-conductor 4 and the power modules 2. Such a configuration makes it possible to bring the bus bar 6 which is a power electricity path being a noise generating source close to the power modules 2 which receives the noise. Therefore, in the present embodiment, it is possible to bring the bus bar 6 close to the power modules 2 and to dispose the bus bar 6 to be layered on the power modules 2 as described above. That is, it is possible to shorten the distance between the PN-conductor 4 and the power modules 2. As a result, it is possible to miniaturize the power conversion apparatus.

(4) The shielding plate 3 is mounted on the heatsink 1.

In this configuration, it is possible to support the bus bar 6 integrated with the shielding plate 3 by the heatsink 1 via the shielding plate 3. As a result, the positioning of the bus bar 6 becomes more ore secure.

Furthermore, the configuration in which the bus bar 6 is supported by and fixed to the shielding plate 3 which is close to and integrated with the bus bar 6 does not need a fixing configuration considering the insulation distance from the PN-conductor 4 which is the power electricity path. Accordingly, it is possible to miniaturize the power conversion apparatus.

(5) Furthermore, the outer diameter of the shielding plate 3 is larger than the outer diameter of the bus bar 6. That is, the shielding plate 3 has the protruding portion protruding to the outer diameter direction from the bus bar 6, when viewed in the layering direction.

In such a configuration, the shielding plate 3 has a shielding area larger than the path where the bus bar 6 and the power modules 2 face each other. Accordingly, it is possible to suppress the noise going around the shielding plate 3, and thus to reduce the malfunction of the power modules 2.

In this specification, the embodiment is described taking the case where the shielding plate 3 and the bus bar 6 have disk-shapes as an example. The shapes of the shielding plate 3 and the bus bar 6 are not necessary to be disk-shapes. The shielding plate 3 only needs to have a shape including a shielding plate 3 body completely overlapping the bus bar 6, and protruding portions which protrude from the shielding plate 3 body to at least one of the inner diameter direction and the outer diameter direction and do not overlap the bus bar 6, when viewed in the layering direction.

(6) The smoothing capacitors are mounted on a surface of the bus bar 6 opposite to the surface facing the shielding plate 3.

Such a configuration makes it possible to configure the power conversion apparatus in which the smoothing capacitors 7 are disposed in a projected area of the bus bar 6 in the axis direction. As a result, it is possible to reduce a margin in volume necessary for the power conversion apparatus, and thus to improve an output density.

(7) The bus bar 6 includes the N-conductor 4 (first conductor) facing the shielding plate 3 and the P-conductor 5 (second conductor) facing the smoothing capacitors 7, which are layered in the layering direction and electrically connected with the terminals of the smoothing capacitor, respectively. The N-conductor 4 includes a non-overlapping portion which does not overlap the P-conductor 5 when viewed in the layering direction, and the step portion 4a is formed at the non-overlapping portion. At least the portion of the step portion 4a which connects with one of the terminals of the smoothing capacitor 7 protrudes toward the one of the terminals.

It is to be noted that the P-conductor 5 may be the first conductor and the N-conductor 4 may be the second conductor.

Such a configuration makes it possible to set the height of each of the upper face of the P-conductor 5 (the second conductor) and the protruding portion of the N-conductor 4 (the first conductor) to be similar to the height of a connection part where the end portions 7a of the pair of the terminals of the smoothing capacitor 7 are connected. Thus, the general-purpose capacitor which has a pair of terminals with equal lengths can be used as the smoothing capacitors 7. Therefore, the mounting of the smoothing capacitors 7 becomes easier and it is possible to reduce the cost of the smoothing capacitors 7

It is to be noted that even if the smoothing capacitors 7 has a pair of terminals with different lengths, it is possible to address the difference in the length by changing the height of the N-conductor 4.

(8) Each of the first conductor and the second conductor has a disk-shape when viewed in the layering direction. And the non-overlapping portion is positioned inner or outer in a diameter direction than the second conductor. The step portion 4a is formed in the annular shape having the notch partially. The respective electricity supply paths 4c and 5c to the first conductor and the second conductor are disposed at the position of the notch.

Such a configuration makes it possible to provide the electricity supply paths 4c and 5c to the pair of the conductors in the form in which these paths pass the notch portion. That is, it is possible to suppress the interference between the electricity supply pathes and the step portion 4a, and to dispose the electricity supply paths 4c and 5c with reduced protrusion in the diameter direction of the bus bar 6, and thus to miniaturize the bus bar 6.

Priority is claimed on Japanese Patent Application No. 2012-205958 (filed on September 19, 2012), the entire content of which is incorporated by reference as a part of this application.

While the present invention has been described with reference to the definite number of embodiments, the scope of the present invention is not limited thereto and modifications of the embodiments based on the above disclosure are obvious to those skilled in the art.

### Reference Signs List

- 1: heatsink
- 2: power module
- 3: shielding plate
- 4: N-conductor (first conductor)
- 4a: step portion
- 4c: electricity supply path
- 5: P-conductor (second conductor)
- 6: bus bar
- 7: smoothing capacitor
- 8: driver circuit substrate
- 9, 10: adhesive insulation sheet
- 13: cylindrical body
- 14: bolt
- 15: mounting portion
- 15a: mounting hole

## Claims

1. A power conversion apparatus comprising,
power modules, a shielding plate, and a bus bar electrically connected with the power modules, which are layered in this order on one side of a heatsink, wherein
the power modules are annularly disposed along a surface of the heatsink, and
the power modules disposed annularly, the shielding plate, and the bus bar are disposed to overlap each other at least partially when viewed in a layering direction.

2. The power conversion apparatus according to claim 1, wherein the shielding plate and the bus bar are bonded.

3. The power conversion apparatus according to claim 2, wherein the shielding plate is supported by the heatsink.

4. The power conversion apparatus according to claim 2 or 3, wherein
the bus bar and the shielding plate have annular shapes when viewed in the layering direction, and
the shielding plate includes a shielding plate body completely overlapping the bus bar, and a protruding portion which protrudes from the shielding plate body to at least one of an inner diameter direction and an outer diameter direction and does not overlap the bus bar, when viewed in the layering direction.

5. The power conversion apparatus according to any one of claims 1 to 4, further comprising a smoothing capacitor mounted on a first surface of the bus bar opposite to a second surface of the bus bar, the second surface facing the shielding plate.

6. The power conversion apparatus according to claim 5, wherein
the bus bar comprises a first conductor facing the shielding plate and a second conductor facing the smoothing capacitor, which are layered in the layering direction and electrically connect with terminals of the smoothing capacitor, respectively,
the first conductor comprises a non-overlapping portion which does not overlap the second conductor, when viewed in the layering direction,
a step portion is formed at the non-overlapping portion, and
at least a portion of the step portion, which connects with one of the terminals of the smoothing capacitor protrudes toward the one of the terminals.

7. The power conversion apparatus according to claim 6, wherein
each of the first conductor and the second conductor has a annular shape when viewed in the layering direction,
the non-overlapping portion is positioned inner or outer in a diameter direction than the second conductor,
the step portion is formed in the annular shape having a notch partially, and
respective electricity supply paths to the first conductor and the second conductor are disposed at a position of the notch.
